# NEW EUROPEAN PATENT SPECIFICATION

(11) **EP 0 437 946 B2**
(45) Date of publication and mention of the opposition decision: **05.04.2000**
(45) Mention of the grant of the patent: 02.04.1997
(21) Application number: 90313653.9
(22) Date of filing: 14.12.1990
(51) Int. Cl.: B65D 65/40, B65D 65/42, C23C 14/20, C23C 14/06, B32B 27/00, H05B 6/64

(54) **Web barrier packaging material**
Bandförmiges Verpackungsmaterial mit Barriereeigenschaften
Bande de matériau d'emballage ayant des propriétés de barrière

(30) Priority: 20.12.1989 GB 8928706
(43) Date of publication of application: 24.07.1991
(73) Proprietor: REXAM PACKAGING LIMITED, London SW1X 7NN (GB)
(72) Inventor: Kelly, Roger Sidney Arthur, Bury-St-Edmunds, Suffolk IP31 1AS (GB); Revell, Kenneth Martin, Thetford, Norfolk IP24 1TP (GB)
(74) Representative: Wain, Christopher Paul

(56) References cited:
- EP-A- 0 343 006
- GB-A- 2 210 826
- JP-A- 6 171 184
- JP-A- 60 242 070
- JP-A- 60 242 071
- JP-A- 62 101 428
- THIN SOLID FILMS, vol. 101, no. 4, March 1983, pages 345-356, Elsevier Sequoia, Lausanne, CH; H. DEMIRYONT et al.: "Characterization of A1-A10x and Sn-SnOx cermet films deposited by reactive evaporation"

## Description

This invention relates to coated web materials suitable for barrier packaging.

The vacuum deposition of metals with low evaporation temperatures, such as aluminium, onto web substrates to produce films with good barrier to oxygen and/or water vapour suitable for barrier packaging is well known and extremely cost-effective, and has been practised for many years. The vacuum deposition of transparent metal oxides or non-metal oxides with good barrier onto web substrates is more difficult because of their much higher evaporation temperatures, but processes for achieving this, such as sputtering or electron beam evaporation, are known. However, these are little used for the production of packaging materials because they are generally slow, technically demanding and consequently uneconomic.

The production of a layered coating of metal and metal oxide (such as aluminium and aluminium oxide) on a web substrate via the reactive evaporation of the metal in the presence of oxygen or an oxygen containing gas or vapour, separating the two components using a baffle, is described in WO-A-82/02687. In the coatings so produced, the relative amounts of the two components vary throughout the coating thickness. Such coated films are described as giving the substrate improved optical and adhesion-promoting properties.

The production of a transparent metal oxide coating (such as aluminium oxide) on a web substrate via the reactive evaporation of the metal in the presence of oxygen or an oxygen containing gas or vapour, in stoichiometric proportions, is described in our British patent application no. 2210826A. If a suitable substrate is used, such coated materials can have a moderate barrier to oxygen and water vapour (using 12 micrometre (12 micron) polyester film as the substrate, an oxygen permeability of 5 cm³ (cc)/metre²/24 hours at 23°C/O % RH and an MVTR of 1.9 grams/metre²/24 hours at 38°C/90 % RH are quoted), but these permeabilities are considered insufficient for barrier packaging of oxygen or moisture sensitive foodstuffs requiring long shelf-life. Techniques are described in this specification 2210826A for converting the transparent oxide coated film to a material with better barrier, adequate for barrier packaging, such as laminating the oxide coated film to itself, or coating the oxide surface with an organic lacquer and depositing a further layer of transparent oxide on this lacquer. However, such techniques of necessity increase cost and reduce viability to a limited range of packaging applications.

An article entitled "Characterization of A1-A10ₓ and Sn-SnOₓ cermet films deposited by reactive evaporation" in Thin Solid Films, 101 (1983), pages 345-356 is an academic study of the effect of A1-A10ₓ stoichiometry on electrical properties.

We have now found that it is possible to produce economically a web material which has an improved barrier to oxygen and/or water vapour, and yet is still substantially transparent to light and microwave radiation, via a modification to the stoichiometry of the reactive evaporation process, in which the substrate is deposited not with the metal oxide, as described in GB 2210826A, or graded layers of metal and metal oxide, as described in European patent 0070875, but with an intimate mixture of metal oxide and a low level of metal. The coating is an essentially uniform mixture of metal and metal oxide. The relative proportions are limited by the requirement that the mixture be microwave transparent, i.e. the amount of metal must not be so much as to significantly absorb microwaves.

In one aspect, the invention provides a web material as a packaging material for oxygen- and/or moisture-sensitive foodstuffs, which material comprises a web substrate of film, paper or board having a gas or moisture barrier coating thereon. wherein the coating comprises a mixture of a metallic element and an oxide of the metallic element, and the amount of the metallic element in the coating is greater than zero, characterised in that the metallic element and the metallic element oxide are essentially uniformly distributed throughout the coating, the amount of the metallic element in the coating is sufficiently low that the web material is substantially transparent to microwave radiation, and the optical density of the coating measured immediately after its deposition is 0.1 to 0.4 higher than that of the uncoated substrate.

In another aspect, the invention provides a method of making the web material described above, which comprises subjecting a web substrate of film, paper or board to a reactive evaporation process wherein an oxygen-containing gas or vapour is introduced directly into a stream of evaporating metallic element to deposit on the substrate a substantially uniform mixture of the metallic element and metallic element oxide, wherein the relative proportions of the oxygen containing gas or vapour and the evaporating metallic element are such that the amount of the metallic element in the coating is greater than zero, and is sufficiently low that the web material is substantially transparent to microwave radiation, and whereon the amount of oxygen-containing gas or vapour introduced is such that the optical density of the coating on the substrate measured immediately after its deposition is 0.1 to 0.4 greater than that of the uncoated substrate prior to exposure to oxygen.

The preferred layer of coating can be described as to its thickness and composition as follows. Its thickness is preferably such that the optical density of a metal layer deposited under the same operating conditions but in the absence of oxygen is from 0.4 to 5.0, more preferably from 1.5 to 3.0, higher than the optical density of the uncoated substrate. Thus, in making a preferred coating of the invention, the process parameters can be first adjusted to achieve a metal deposition (in the absence of oxygen) to give the above optical density increase, so that those parameters can thereafter remain unchanged but oxygen is admitted.

Thus, one way of making preferred coatings of the invention is to first deposit metal alone (no oxygen) to achieve the described coating thickness (measured by optical density increase) and then admit oxygen until the optical density decreases to the range given, and the coatings thereafter formed are preferred coatings of the invention.

The actual barrier achieved is dependent on the film substrate used, which can include polyester, polyamide, polyolefine, polyvinyl chloride, polyvinylidene chloride, polysulphone, polyacrylonitrile or regenerated cellulose films, including copolymers, blends, composites or co-extrusions of these materials, or variants coated with other plastics. Certain papers and boards, coated with suitable plastics, are also included. In general, the reactive evaporation process can be applied to any substrate which can be vacuum deposited with a metal such as aluminium.

In one embodiment of the invention, poly(ethylene glycol) terephthalate or nylon 6 films are preferred, since when coated with the above mentioned metal oxide/metal mixture, they have low permeability to oxygen and water vapour, and are suitable, (where necessary laminated to, or coated with, a heat sealable material such as a polyolefine) for packaging oxygen or moisture sensitive foodstuffs or other materials. Barrier is further enhanced by lamination. Such laminates, which are substantially transparent to both light and microwave radiation, can be used as environmentally friendly alternatives to laminates of poly(ethylene glycol) terephthalate/polyvinylidene chloride/polyethylene, eg. for applications such as lidding of food containers packed using the process of modified or controlled atmosphere packaging. Unlike the polyvinylidene chloride containing laminates, they can be disposed of by incineration without producing hydrogen chloride, which is deleterious to the environment.

Oxygen and moisture barrier achieved will vary according to the substrate, the metal/oxide coating thickness and the metal/oxide stoichiometry. The effect of the last parameter on a metal/oxide coated film based on a poly(ethylene glycol) terephthalate substrate is illustrated in example 1 below.

The metal oxide/metal mixture can be coated on one or both sides of the substrate. Two side coating can be advantageous for some applications, eg. a poly(ethylene glycol) terephthalate film coated on both sides with the metal oxide/metal mixture, and having good barrier to oxygen and water vapour, can be used as an alternative to aluminium foil in composites, such as board/polyethylene/foil/polyethylene, used for the production of cartons for aseptic packaging of liquids or particulate/liquid suspensions. Such alternative composites can be produced by existing processes such as tandem extrusion lamination, or by other lamination techniques. Cartons produced by such techniques have advantages over the traditional foil composite cartons, eg. they can be reheated in microwave ovens.

In another embodiment of the invention, a substantially transparent regenerated cellulose film with good barrier to oxygen and water vapour can be produced by coating a regenerated cellulose base film with a lacquer such as those described in our European patent specification no. 0340910A, and then coating with the metal/oxide mixture. Such a film is a more environmentally friendly alternative to the polyvinylidene chloride coated regenerated cellulose films currently used for barrier packaging of foodstuffs.

In another embodiment of the invention, a substantially transparent polyolefine film with good barrier to oxygen and water vapour can be produced by coating a polyolefine film with a lacquer such as those described in our European patent specification no. 0340910A, and then coating with the metal/oxide mixture. Such a film can be laminated to a reverse printed film, to produce a barrier laminate with sandwiched print suitable for barrier packaging.

The metal used in the reactive evaporation process can be any metal which forms an oxide with good barrier properties, such as aluminium, magnesium or tin.

The gas used in the reactive evaporation process can be oxygen or any other gas or vapour containing oxygen such as water vapour or carbon monoxide or dioxide.

It is essential that the oxygen or oxygen gas is introduced directly into the stream of evaporating metal and not otherwise into the vacuum chamber as a whole. The gas is introduced directly into the stream of evaporating metal and not otherwise into the vacuum chamber as a whole. The gas is preferably introduced via a pipe into the centre of the stream of evaporating metal. This pipe is preferably terminated by a nozzle or other spreading device which will cause the gas to spread throughout the stream, thus producing a consistent mixture of oxide and metal on the substrate with no bands of high metal and high oxide content. Thus, the coating formed is an essentially homogeneous mixture of metal and metal oxide throughout.

The thickness of the metal/oxide coating should be in a range such that it provides good adhesion to the substrate and has good mechanical strength and barrier. Thickness is most easily specified by reference to the optical density of a metal layer formed under the same operating conditions but in the absence of oxygen. An optical density of 0.4 to 5.0 higher than the optical density of the substrate gives the required properties, the range 1.5-3.0 being especially preferred. These optical densities of metal appear to equate to coat weights of metal/oxide mixture of approximately 0.04-0.5 and 0.15-0.30 grams/metre², but since these latter coat weights are difficult to measure analytically without specialist equipment, the former specification is preferred.

We have been unable to determine analytically the preferred ratio of oxide to metal in the mixture. However, it can be defined by reference to the optical density, which should be between 0.10 and 0.40 higher than the optical density of the substrate, measured immediately after coating of the mixture on the substrate, which equates approximately to an optical density between 0.0 and 0.25 higher than the optical density of the substrate after fading due to oxidation in the atmosphere has taken place (see example 1). At the lower limit (i.e. close to the stoichiometric mixture of metal and oxygen), barrier begins to deteriorate to an unacceptable level. At the upper limit (metal rich). the coating becomes brown in colour and begins to absorb microwave radiation. For films coated on both sides, these optical density figures will be additive. It is to be noted that the coated films of the invention are microwave transparent, which places a maximum on the amount of free metal which can be present therein.

In order that the invention may be more fully understood, reference is made hereafter to the accompanying drawings, in which:
FIG. 1 is a diagrammatic representation of one form of apparatus arranged to carry out the process of the invention; and
FIG. 2 is a graph of oxygen permeability (ordinate) against optical density at time of production (abscissa), for polyester film coated with an aluminium/aluminium oxide mixture, as described in Example 1;
FIG. 3 is a graph of MVTR (ordinate) against optical density at time of production (abscissa), for polyester film coated with an aluminium/aluminium oxide mixture, as described in Example 1;
FIG. 4 is a graph of oxygen permeability (ordinate) against optical density (abscissa), for a coated polyester/polyethylene laminate as described in Example 1; and
FIG. 5 is a graph of MVTR (ordinate) against optical density (abscissa) for a coated polyester/polyethylene laminate as described in Example 1.

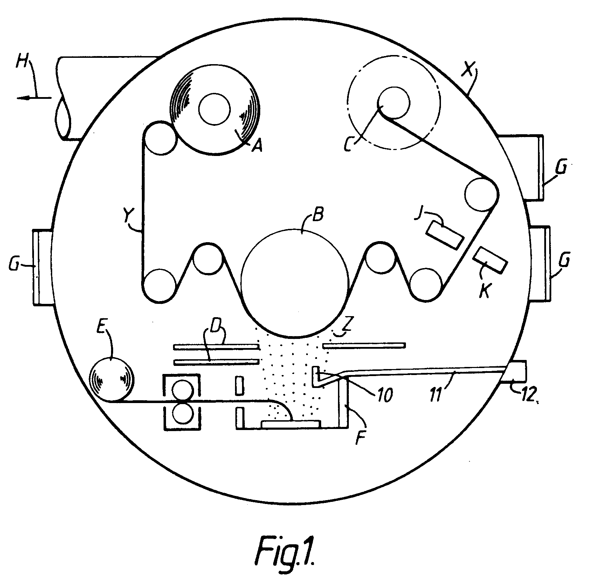

The reactive evaporation process of the invention can be carried out in a suitably modified conventional film metallising chamber. Figure 1 of the accompanying drawings is a diagrammatic representation of one embodiment of the apparatus, which comprises a vacuum chamber X for depositing a layer of metal such as aluminium on one surface of a continuous web of plastic film. Within the chamber is a supply reel A from which film Y passes over a cooled drum B to take up reel C. An aperture and shutter assembly D controls the zone of evaporation of a metal supplied from a wire feed E to a ceramic heater block F maintained at a temperature above the evaporation temperature of the metal at the chamber pressure. The chamber is provided with an array of collimated light sources J across the width of the film and a corresponding array of photocells K so that the light transmission of the film can be measured after coating. The chamber is provided with viewing ports G and is connected at H to vacuum pumps. When used for conventional metallisation, vaporised metal from the heatrer flows in a zone of evaporation, indicated by broken lines Z, towards drum B and condenses on the film overlying the drum. In accordance with the present invention, there is provided a discharge nozzle 10 connected by a pipe 11 to an inlet 12 for receiving a supply of a gas or vapour (not shown). The nozzle 10 is located either within the zone Z or between the heaters, and is directed in the direction of vapour flow from the heater to the drum. Several such assemblies may be mounted across the chamber to facilitate coating of wide films. It is a crucial feature of the invention that the gas is introduced into the zone of vaporising metal. If the gas is merely introduced into the chamber outside this zone, this produced a pressure rise within the chamber causing unsatisfactory deposition and eventually the mean free path of the vaporised metal is so reduced that no deposition occurs.

In order that the invention may be more fully understood, the following Examples are given by way of illustration only.

### Example 1

A 1,400 mm wide web of 12 micrometres (12 micron) poly(ethylene glycol) terephthalate film (Melinex 800 ex-ICI Films) was placed inside a metallising chamber similar to that shown diagrammatically in Figure 1, and threaded from the offwind position A, over the drum B, onto the wind up position C. Twelve ceramic heaters F were arranged across the web and spaced 20 centimetres from drum B.

A nozzle 10 was located between each heater, all the nozzles being connected to the inlet 12 to which was connected a supply of oxygen gas. Both the gas supply and the flow to each individual nozzle were controllable by adjustable valves. The chamber was evacuated to a pressure of 133.32 kPa (10⁻³ torr) and aluminium wire fed to each heater at a rate of 30 grams/minute, with the shutter D closed. The web was accelerated to a speed of 300 metres/minute and optical density of the uncoated web measured at 0.04. The shutter was then opened in order to coat the film with aluminium. Initially, approximately 25% of the aluminium evaporated was deposited on the web, giving a coating weight of about 0.1 grams/metre² and an optical density of about 2.5. Heater temperatures and wire feed rates were adjusted to give a generally even optical density across the web (this is not critical to the process). Oxygen was then discharged through the nozzles and the flow rate increased until the coating on the film became just transparent, i.e. the optical density of the coated film was 0.04, similar to the optical density of the base film. Oxygen flow rates to individual nozzles were adjusted to give an even coating across the web with no significant bands of different optical density. Chamber pressure was maintained at approximately 133.32 kPa (10⁻³ torr). Oxygen flow rate was then progressively reduced at the main oxygen inlet control, adjusting the flow rates to individual nozzles where necessary to keep optical density even across the web. A range of optical densities from 0.05 to 0.55 were produced.

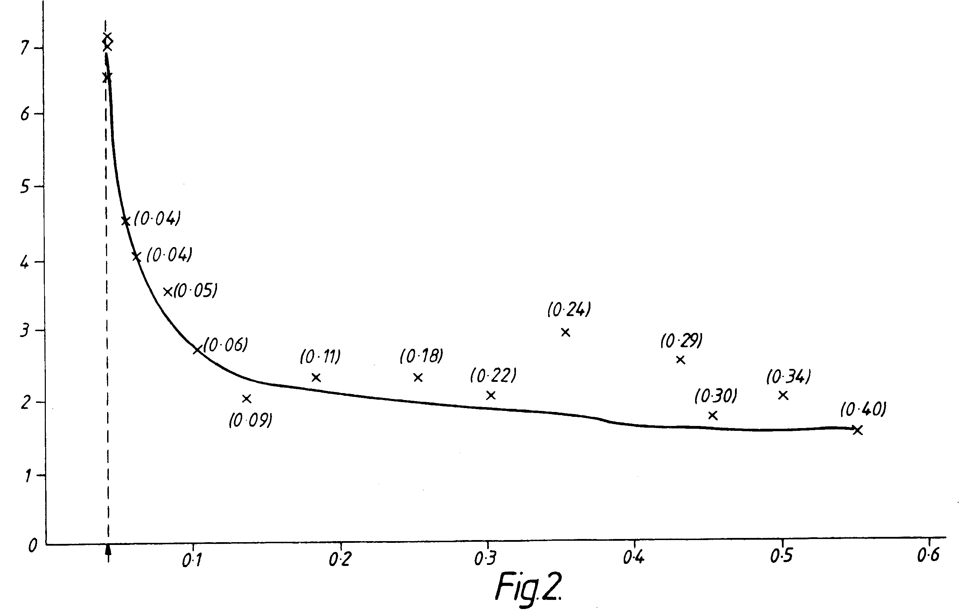

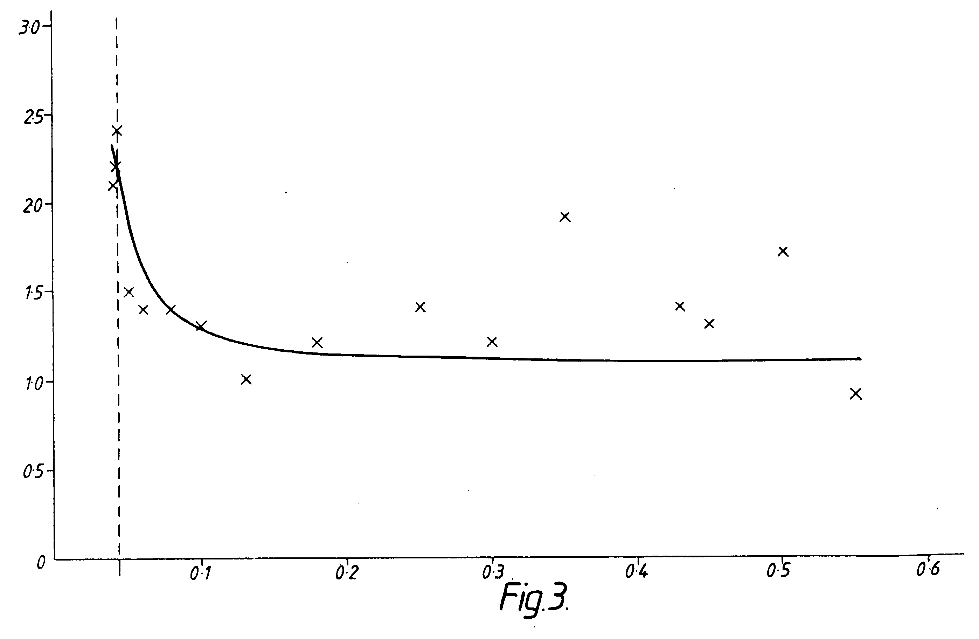

At the end of the experiment, when the reel was removed from the chamber, and unreeled to obtain samples, thus exposing it to air, its optical density fell rapidly (ie. within a few seconds) by between 0.01 and 0.1. Optical density then declined more slowly (by 0 - 0.05) over a period of about one month, eventually stabilising. Oxygen permeability and MVTR of the 12 micrometres (12 micron) polyester film before metallising were respectively 120 cm³ (cc)/metre²/24 hours (at 23 °C, 0 % RH) and 40 grams/metre²/24 hours (at 38 °C, 0 % RH). Oxygen permeability and moisture vapour transmission rate of the various samples in the reel are shown graphically in Figures 2 and 3. Optical density referred to on the scale is that prior to fading. Optical densities after fading are shown in brackets. Tests indicated that barrier was not affected by fading.

In Figs. 2 and 3, the value of optical density indicated by the arrow on the abscissa (about 0.04) indicates that of the base polyester film. The values at permeability 6 to 7 and MVTR 2.0 to 2.5 are those of the clear oxide coating. In Fig. 2, the units of oxygen permeability are cm³ (cc)/m²/24 hours at 23 °C/0% RH, and the optical densities in brackets were measured after 1 month. In Fig. 3, the units for MVTR are g/m²/24 hours at 38°C/90% RH.

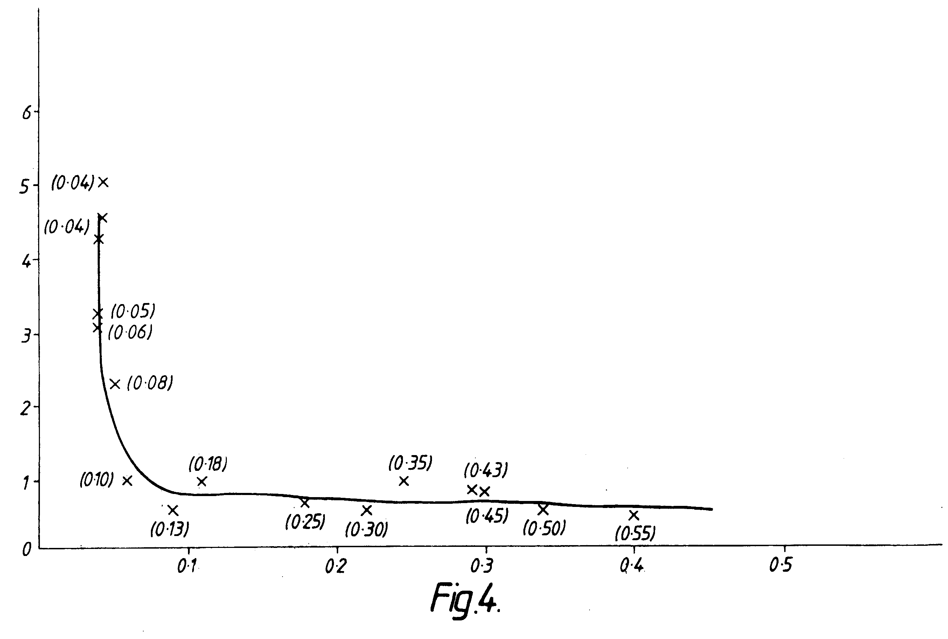

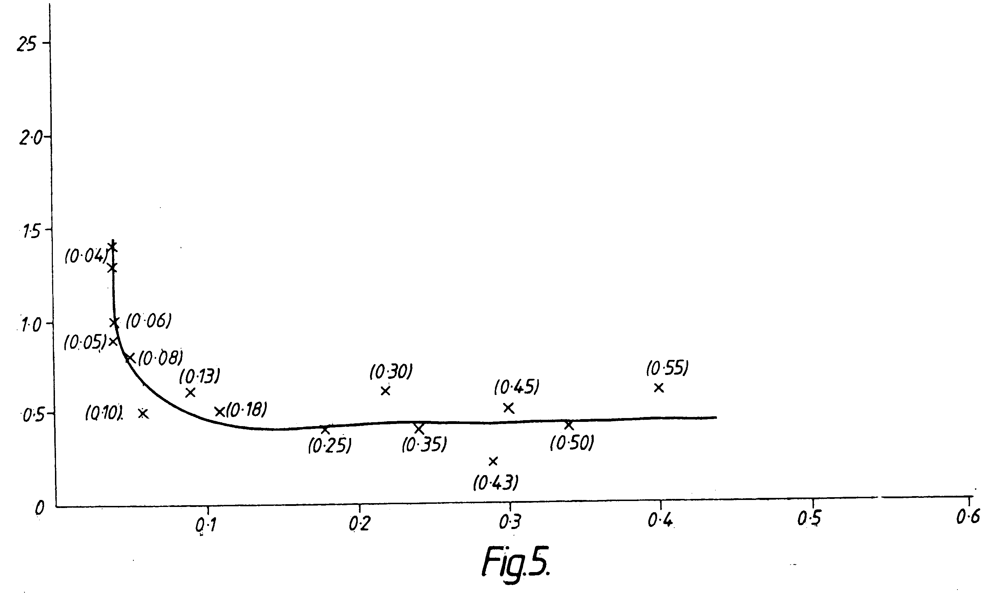

Samples of film having various optical densities were coated on the oxide surface with a layer of a commercially available two component polyurethane adhesive and dried to give a coat weight of 2.8 grams/metre². The adhesive coated surface was then calendered to the corona treated surface of a commercially available 50 micrometres (50 micron) low density polyethylene (LDPE) film and left for one week to allow the adhesive to cure. After curing, oxygen permeability and MVTR were re-measured on the laminate, and showed significant improvement over the original unlaminated film. Results are shown graphically in Figs. 4 and 5.

In Fig. 4, the units of oxygen permeability are cm³ (cc)/m²/24 hours at 23°C/ 0% RH. In Figs. 4 and 5, the numbers in brackets are the optical density before fading (ie. the original optical density). The clear oxide coating has an optical density of 0.04 (oxygen permeability 4 to 5 and MVTR about 1.5). On both graphs, materials to the left of the vertical line at O.D. about 0.29, have no microwave interaction, whereas those to the right of the line (ie. greater than about 0.29 OD) do have microwave interaction.

Samples of laminate of various optical densities were made into pouches by heat sealing around 3 sides filled with water and heated in a 600 watt microwave oven. Pouches made from laminate with low optical densities heated up effectively without sparking, but those made with high optical density laminates absorbed the microwave energy, sparked and caused the pouch to deform and leak. The transition between a usable and unusable product appeared to be at about optical density 0.29 (ie. a coating optical density of 0.25 when optical density of the substrate is excluded) equivalent to an optical density of the original coated film before fading of about 0.44 (0.40 after correction for substrate optical density).

### Example 2

A 1,400mm wide web of a commercially available 40 micrometres (40 micron), low slip, linear low density polyethylene film, corona treated on one side, and having an oxygen permeability of greater than 1,000 cm³ (cc)/metre²/24 hours (at 23 °C/0 % RH) and an MVTR of greater than 5 grams/metre²/24 hours at (38 °C/90 % RH), was coated on the corona treated surface with 1.5 grams/metre² of a proprietary solvent-based lacquer based on a polyester resin of the type described in our European patent application no. 89303285.4. The coated surface of this film was vacuum deposited with an aluminium/aluminium oxide mixture to an optical density 0.11 higher than the optical density of the original substrate (0.04) by the technique described in Example 1. After fading, the film had a final optical density of 0.07, an oxygen permeability of 5.8 cm³ (cc)/metre²/24 hours at 23 °C/0 % relative humidity (RH) and an MVTR of 0.8 gram/metre²/24 hours at 38 °C/90 % RH. The oxide coated surface of the film was laminated, using the technique and conditions described in Example 1, to a reverse printed 12 micron poly(ethylene glycol) terephthalate film. After lamination and curing of the adhesive, the laminate had an oxygen permeability of 1.0 cm³ (cc)/metre²/24 hours at 23 °C/0 % RH, and MVTR of 0.3 grams/metre²/24 hours at 38 °C/90 % RH, an interply bond strength of greater than 300 grams/25 mm, and did not significantly attenuate microwave radiation.

### Example 3

A 1,400 mm wide web of 320 gauge regenerated cellulose film (Cellophane MS ex-British Cellophane Ltd) was coated on both sides with 1.5 grams/metre² of a proprietary solvent-based lacquer based on a polyester resin of the type described in our European patent specification no. 0340910A. One surface of this film was vacuum deposited with an aluminium/aluminium oxide mixture to an optical density 0.13 higher than the optical density of the original substrate (0.04) by the technique described in Example 1. After fading, the film had a final optical density of 0.07, an oxygen permeability of 0.3 cm³ (cc)/metre²/24 hours at 23 °C/0 % RH, an MVTR of 2.9 grams/metre²/24 hours at 38 °C/90 % RH, and did not significantly attenuate microwave radiation.

## Claims

1. A web material useful as a packaging material for oxygen- and/or moisture-sensitive foodstuffs, which material comprises a web substrate of film, paper or board having a gas or moisture barrier coating thereon, wherein the coating comprises a mixture of a metallic element and an oxide of the metallic element, and the amount of the metallic element in the coating is greater than zero, characterised in that the metallic element and the metallic element oxide are essentially uniformly distributed throughout the coating, the amount of the metallic element in the coating is sufficiently low that the web material is substantially transparent to microwave radiation, and the optical density of the coating measured immediately after its deposition is 0.1 to 0.4 higher than that of the uncoated substrate.

2. A material according to claim 1, wherein the web substrate comprises polyester, polyamide, polyolefin, polyvinyl chloride, polyvinylidene chloride, polysulphone, polyacrylonitrile or regenerated cellulose, or any copolymer, blend, composite or co-extrusion thereof, or variant with other plastic materials, or a paper or board coated with a suitable plastics material.

3. A material according to claim 2, wherein the web material is poly(ethylene glycol) terephthalate or nylon-6, optionally laminated to or coated with a heat-sealable material.

4. A material according to any preceding claim, wherein the metallic element is aluminium or tin.

5. A material according to any preceding claim which is laminated to another web or coated on another material.

6. A method of making a web material according to claim 1, which comprises subjecting a web substrate of film, paper or board to a reactive evaporation process wherein an oxygen-containing gas or vapour is introduced directly into a stream of evaporating metallic element to deposit on the substrate a substantially uniform mixture of the metallic element and metallic element oxide, wherein the relative proportions of the oxygen containing gas or vapour and the evaporating metallic element are such that the amount of the metallic element in the coating is greater than zero, and is sufficiently low that the web material is substantially transparent to microwave radiation, and wherein the amount of oxygen-containing gas or vapour introduced is such that the optical density of the coating on the substrate measured immediately after its deposition is 0.1 to 0.4 greater than that of the uncoated substrate, prior to exposure to oxygen.

7. A method according to claim 6, wherein the amount of the metallic element deposited is such as to provide, in the absence of oxygen, an optical density of 0.4 to 5.0 greater than the optical density of the uncoated substrate.

## Patentansprüche

1. Als Verpackungsmaterial für gegen Sauerstoff und/oder Feuchtigkeit empfindliche Nahrungsmittel geeignetes Vliesmaterial, das ein Vliessubstrat aus Folie, Papier oder Karton umfaßt, auf dem sich eine' Beschichtung als Gas- oder Feuchtigkeitssperre befindet, bei welchem die Beschichtung eine Mischung eines metallischen Elements und eines Oxids des metallischen Elements enthält, **dadurch gekennzeichnet, daß** das metallische Element und das Oxid des metallischen Elements im wesentlichen gleichförmig durch die Beschichtung verteilt sind, die Menge des metallischen Elements in der Beschichtung genügend niedrig ist, daß das Vliesmaterial für Mikrowellenstrahlung im wesentlichen transparent ist, und die optische Dichte der Beschichtung, gemessen unmittelbar nach ihrem Aufbringen auf das Vliesmaterial um 0,1 bis 4,0 höher ist als die des umbeschichteten Substrats.

2. Material nach Anspruch 1, bei dem das Vliessubstrat aus Polyester, Polyamid, Polyolefin, Polyvinylchlorid, Polyvinylidenchlorid, Polysulfon, Polyacrylonitril oder Celluloseregenerat oder einem Mischpolymerisat, einer Mischung, einem Verbundstoff oder einem Coextrudat derselben oder einer Variante mit anderen Kunststoffmaterialien oder aus mit geeignetem Kunststoffmaterial beschichtetem Papier oder Karton besteht.

3. Material nach Anspruch 2, bei dem das Vliesmaterial aus Poly(ethylenglycol)terephthalat oder Nylon-6 besteht, das wahlweise auf ein heißsiegelfähiges Material kaschiert oder damit beschichtet ist.

4. Material nach einem der vorhergehenden Ansprüche, bei dem das metallische Element Aluminium, Magnesium oder Zinn ist.

5. Material nach einem der vorhergehenden Ansprüche, das auf ein anderes Vliesmaterial kaschiert oder als Beschichtung aufgebracht ist.

6. Methode zur Herstellung eines Vliesmaterials nach Anspruch 1, die folgendes umfaßt: Unterwerfen eines Vliessubstrats aus Folie, Papier oder Karton einem Reaktionsverdampfungsverfahren, bei dem ein sauerstoffhaltiges Gas bzw. sauerstoffhaltiger Dampf direkt in einen Strom von verdampfendem metallischen Element eingeführt wird zur Ablagerung einer im wesentlichen gleichförmigen Mischung des metallischen Elements und des Oxids des metallischen Elements auf dem Substrat, wobei die relativen Anteile an sauerstoffhaltigem Gas bzw. Dampf und an verdampfendem metallischem Element so groß sind, daß die Menge des metallischen Elements in der Beschichtung größer als null und genügend niedrig ist, daß das Vliesmaterial für Mikrowellenstrahlung im wesentlichen transparent ist, und wobei, die Menge des eingeführten sauerstoffhaltigen Gases bzw. Dampfes so groß ist, daß die optische Dichte der sofort nach der Ablagerung gemessenen Beschichtung auf dem Substrat vor der Exposition an Sauerstoff 0,1 bis 0,4 höher liegt als diejenige des unbeschichteten Substrats.

7. Methode nach Anspruch 6, bei der die Menge des abgelagerten metallischen Elements so groß ist, daß sie in Abwesenheit von Sauerstoff zu einer optischen Dichte führt, die 0,4 bis 5,0 höher liegt als die optische Dichte des unbeschichteten Substrats.

## Revendications

1. Un matériau en bande continue utilisable comme matériau d'emballage pour denrées alimentaires sensibles à l'oxygène et/ou l'humidité qui comporte un substrat en bande continue en film, papier ou carton avec un enduit barrière contre les gaz ou l'humidité, dans lequel l'enduit comporte un mélange d'un élément métallique et d'un oxyde de cet élément métallique, et la quantité de l'élément métallique dans l'enduit étant supérieure à zéro, caractérisé en ce que l'élément métallique et son oxyde sont essentiellement répartis de manière uniforme dans l'enduit, la quantité d'élément métallique dans l'enduit étant suffisamment faible pour que ce matériau en bande continue soit fondamentalement transparent aux radiations électromagnétiques et la densité optique de l'enduit mesurée immédiatement après son application étant de 0,1 à 0,4 fois supérieure à celle du substrat non revêtu.

2. Un matériau conforme à la revendication 1 dont le substrat en bande continue est constitué de polyester, de polyamide, de polyoléfine, de poly(chlorure de vinyle), de poly(chlorure de vinylidène), de polysulfone, de polyacrylonitrile ou de cellulose régénérée ou de n'importe quel copolymère, mélange, composite ou extrusion en couches multiples de ces matériaux ou de variantes avec d'autres matériaux plastiques ou d'un papier ou carton enduit d'un matériau plastique adéquat.

3. Un matériau conforme à la revendication 2, dont le matériau en bande continue est du téréphtalate de poly(éthylèneglycol) ou du nylon-6 éventuellement stratifié à ou enduit par un matériau thermoscellable.

4. Un matériau conforme aux revendications précédentes dont l'élément métallique est l'aluminium, ou l'étain.

5. Un matériau conforme aux revendications précédentes qui est stratifié à une autre bande continue ou enduit sur un autre matériau.

6. Un méthode permettant de produire un matériau en bande continue conformément à la revendication 1 qui soumet un substrat en bande continue en film, papier ou carton à un processus réactif d'évaporation dans laquelle un gaz ou une vapeur contenant de l'oxygène est introduit directement dans un courant d'élément métallique en évaporation pour déposer sur le substrat un mélange fondamentalement uniforme de cet élément métallique et de son oxyde, les proportions relatives du gaz ou de la vapeur contenant de l'oxygène et de l'élément métallique en évaporation étant telles que la quantité de l'élément métallique dans l'enduit est supérieure à zéro et suffisamment faible pour que ce matériau en bande continue soit substantiellement transparent aux radiations électromagnétiques, et dans laquelle la quantité de gaz ou de vapeur contenant de l'oxygène introduite est telle que la densité optique de l'enduit sur le substrat mesurée immédiatement après son application est supérieure de 0,1 à 0,4 à celle du substrat non enduit avant son exposition à l'oxygène.

7. Une méthode conforme à la revendication 6, suivant laquelle la quantité de l'élément métallique déposé est telle qu'elle peut, en l'absence d'oxygène, assurer une densité optique supérieure de 0,4 à 5,0 à celle du substrat non enduit.
